# DEMANDE DE BREVET EUROPEEN

(11) **EP 4 542 636 A1**
(43) Date de publication de la demande: **23.04.2025**
(21) Numéro de dépôt: 24207112.4
(22) Date de dépôt: 17.10.2024
(51) Int. Cl.: H01L 23/10, H01L 21/50, H01L 23/04, H01L 23/043, H01L 23/047, H01L 23/057, H01L 23/36, H01L 23/40

(54) **MODULE DE PUISSANCE ET PROCÉDÉ DE FABRICATION**

(30) Priorité: 18.10.2023 FR 2311283
(71) Demandeur: Commissariat à l'Energie Atomique et aux Energies Alternatives, 75015 Paris (FR)
(72) Inventeur: PORLAN, Manon, 38054 Grenoble (FR); MARCAULT, Emmanuel, 38054 Grenoble (FR)
(74) Mandataire: Cabinet Nony

(57) **Abrégé**

Module de puissance (1) comportant :
- Un premier élément de boîtier (10) présentant un premier logement (12) de réception d'une première puce (70 ; 70' ; 70"),
- une première puce (70 ; 70' ; 70") au moins partiellement reçue dans le premier logement, présentant des contacts électriques (71, 72, 73 ; 71', 72', 73' ; 71", 72", 73"),
- des éléments de connectique (41, 43, 45) reliés électriquement aux contacts électriques de la première puce,
- au moins une cale isolante (90 ; 90' ; 90") disposée au moins partiellement dans le premier logement de manière à recouvrir au moins partiellement ladite puce, présentant au moins une ouverture (91, 92 ; 91', 92' ; 91", 92") ménageant un accès à au moins un contact électrique de la puce à travers la cale et/ou au moins une piste (97") assurant la connexion avec l'un des éléments de connectique et/ou une capacité.

## Description

La présente invention concerne les modules de puissance à semi-conducteurs et leurs procédé de fabrication.

### Technique antérieure

Les modules de puissance comportent généralement au moins deux puces électroniques qui sont électriquement reliées à des éléments de connectique tels que des pattes métalliques et peuvent également comporter une ou plusieurs capacités qui sont électriquement reliées aux puces ou aux éléments de connectique.

Des exemples de modules de puissance sont divulgués dans les publications FR3115651, WO2018/024973 et US9041183.

Dans la demande WO2018/024973, les puces sont reçues dans des logements de forme adaptée d'un support.

Les modules de puissance existants sont développés spécifiquement pour des puces données et tiennent compte de la taille de la puce et de l'emplacement des contacts électriques. Ainsi, certains comportent des pistes électriques sérigraphiées qui dépendent de la disposition de ces contacts.

Un inconvénient de ces modules tient à l'impossibilité d'utiliser d'autres puces que celles pour lesquelles le module a été développé, sans avoir à revoir en profondeur le procédé de fabrication, notamment les étapes de sérigraphie et/ou la forme des supports recevant les puces.

Or, les fabricants de modules sont parfois exposés à des difficultés d'approvisionnement qui obligent à changer de fournisseurs de puces, et la refonte du procédé de fabrication lors d'un changement de modèle de puce et l'utilisation d'un nouveau modèle qui ne présente pas les mêmes dimensions et/ou dispositions des contacts génère des délais de fabrication et un surcoût non négligeables.

### Exposé de l'invention

En conséquence, il existe un besoin pour remédier à cet inconvénient.

### Résumé de l'invention

L'invention vise à répondre à ce besoin et elle y parvient, selon l'un de ses aspects, en proposant un module de puissance comportant :
- Un premier élément de boîtier présentant un premier logement de réception d'une première puce,
- une première puce au moins partiellement reçue dans le premier logement, présentant des contacts électriques,
- des éléments de connectique reliés électriquement aux contacts électriques de la première puce,
au moins une cale isolante disposée au moins partiellement dans le premier logement de manière à recouvrir au moins partiellement ladite puce, présentant au moins une ouverture ménageant un accès à au moins un contact électrique de la puce à travers la cale et/ou au moins une piste assurant la connexion avec l'un des éléments de connectique et/ou une capacité éventuelle

Grâce à l'invention, il est possible d'utiliser plusieurs puces ayant des dimensions et/ou dispositions des contacts différentes, tout en limitant les changements à apporter au module lors du passage d'un modèle de puce à un autre.

En effet, des cales différentes peuvent être utilisées en fonction des puces pour rendre celles-ci compatibles avec une grande partie des éléments constitutifs du module, qui peuvent ainsi rester inchangés.

Cela simplifie grandement le remplacement d'une puce par une autre, car il n'est plus nécessaire comme dans l'état de l'art de revoir en profondeur le procédé de fabrication.

Ainsi, dans des exemples préférés de mise en oeuvre de l'invention, la cale est le seul élément devant être modifié pour permettre l'utilisation d'une puce différente sur un module existant.

Le module peut comporter :
- Un deuxième élément de boîtier présentant un deuxième logement de réception d'une deuxième puce,
- un troisième élément de boîtier disposé entre les premier et deuxième éléments de boîtier, présentant notamment au moins un troisième logement de réception d'une capacité,
- une deuxième puce au moins partiellement reçue dans le deuxième logement, présentant des contacts électriques,
- des éléments de connectique reliés électriquement aux contacts électriques de la deuxième puce,
- au moins une capacité reçue au moins partiellement dans le troisième logement et reliée électriquement à l'une au moins des puces et/ou aux éléments de connectique.

### Cale

La cale peut être réalisée sans aucun élément conducteur tel qu'une piste électrique ou en variante avec au moins un tel élément conducteur.

La cale peut être réalisée en tout matériau adapté, notamment céramique ou autre, sa forme étant obtenue par frittage, impression 3D, usinage ou autrement.

La cale préexiste lors de sa mise en place dans le logement correspondant du module.

La forme de la cale dépend du modèle de puce qui lui est associé.

Dans des exemples, la cale présente sur un bord au moins une ouverture latérale dans laquelle s'engage un élément de connectique correspondant, connecté électriquement à un contact de la puce. Cet élément de connectique est par exemple une patte métallique de connexion électrique, de section transversale aplatie.

Dans des exemples, la cale présente sur deux bords longitudinaux opposés deux ouvertures latérales respectives dans lesquelles s'engagent deux éléments de connectique correspondants connectés électriquement à deux contacts respectifs de la puce. Ces éléments de connectique sont par exemple des pattes métalliques s'étendant dans des directions opposées du module de puissance. Il s'agit par exemple de contacts correspondant à des bornes de puissance d'un transistor, telles que la source ou le drain.

Le ou les éléments de connectique peuvent être soudés au(x) contact(s) correspondant(s) de la puce par tout moyen, par exemple à l'aide de pâte à braser disposée à l'interface des composants à souder entre eux.

La cale peut présenter sur un bord sensiblement perpendiculaire aux bords longitudinaux précités une ouverture additionnelle dans laquelle s'engage un élément de connectique additionnel connecté électriquement à un contact respectif de la puce. Il s'agit par exemple d'un contact correspondant à une borne de commande, par exemple un contact de grille d'un transistor de puissance.

Cet élément de connectique additionnel peut être soudé directement à un contact correspondant de la puce, ou en variante la cale porte une piste électrique soudée à un contact correspondant de la puce et l'élément de connectique additionnel est soudé à la piste.

Le premier logement qui reçoit la puce peut présenter un contour de forme rectangulaire ou autre, la forme rectangulaire étant toutefois préférée.

La puce peut ne pas occuper tout le logement en question, en vue de dessus.

Lorsque la puce occupe tout le logement en vue de dessus, le logement peut permettre le positionnement de la puce dans celui-ci, à un jeu de montage près. Dans ce cas, la cale peut juste se superposer à la puce sans s'interposer entre celle-ci et un ou plusieurs bords du logement. La puce peut alors n'avoir qu'un rôle de compensation d'épaisseur, d'aide au positionnement des éléments de connectique et éventuellement servir aussi à la réalisation d'une connexion électrique entre un contact de la puce et un élément de connectique qui ne lui est pas directement superposé.

Par contre, lorsque la puce n'occupe pas en vue de dessus tout le logement, la cale participe avantageusement à son positionnement dans le logement en s'insérant entre celle-ci et au moins un bord du logement.

Ainsi, dans des exemples de réalisation, la cale est plus longue que la puce à son contact, et présente au moins une portion engagée dans le logement entre la puce et l'élément de boîtier définissant le logement recevant la puce. La cale s'interpose par exemple sur au moins trois côtés, notamment quatre côtés, entre la puce et l'élément de boîtier définissant le logement recevant la puce.

La cale peut présenter une face sensiblement coplanaire avec une face de l'élément de boîtier définissant le logement recevant la puce en contact avec la cale.

### Autres caractéristiques

Le troisième élément de boîtier peut présenter des logements de réception d'éléments de connectique positionnés de manière à permettre de superposer ceux-ci avec des contacts électrique de la deuxième puce.

Les éléments de boîtier peuvent être traversés par des trous permettant le passage d'organes de maintien des éléments de boîtier à l'état assemblé, notamment des vis.

Le module peut comporter au moins un élément de transfert thermique en contact avec une face extérieure d'une puce, mieux deux éléments de transfert thermique en contact chacun avec une face extérieure d'une puce respective, ce ou ces éléments de transfert thermique comportant chacun de préférence une plaque d'un métal, de préférence du cuivre.

### Gamme de modules

L'invention a encore pour objet une gamme de modules de puissance, comportant au moins un premier et un deuxième module selon l'invention, au moins l'une des puces du premier module étant différente d'une puce correspondante de l'autre module, les deux modules comportant des cales différentes et au moins des premier et deuxième éléments de boîtier identiques. Par « puce différente » il faut comprendre que le modèle de puce est différent, par au moins l'une de leurs dimensions, notamment longueur et/ou largeur, et/ou la disposition des contacts.

Les éléments de connectique peuvent être identiques, de même que le troisième élément de boîtier.

### Procédé de fabrication

L'invention a encore pour objet un procédé de fabrication d'un module de puissance, notamment un module selon l'invention, tel que défini ci-dessus, ce module comportant :
- un élément de boîtier inférieur présentant un premier logement de réception d'une première puce,
- une première puce au moins partiellement reçue dans le premier logement, présentant des contacts électriques,
le procédé comportant l'étape consistant à :
- recouvrir avec une cale isolante la puce présente dans le premier logement, cette cale définissant au moins une ouverture se superposant à au moins un contact électrique de la puce ou présentant une piste électrique à relier à un contact électrique de la puce, notamment une piste débouchant sur une ouverture de la cale destinée à recevoir un élément de connectique.

Dans un tel procédé, la cale peut participer au positionnement d'un ou plusieurs éléments de connectique relativement à la puce et au positionnement de la puce dans le logement, notamment lorsque ce dernier est plus grand que la puce en vue de dessus et que celle-ci s'interpose entre au moins un bord du logement et la puce. la cale étant choisie parmi plusieurs cales préexistantes en fonction du type de puce utilisé, toutes ces cales étant adaptées à se positionner dans le logement de l'élément de boîtier inférieur.

Les cales sont par exemple choisies parmi un ensemble de cales comprenant :
- une cale d'épaisseur de préférence sensiblement constante, présentant deux ouvertures opposées sur ses grands côtés et une ouverture sur un petit côté, les dimensions de la cale correspondant sensiblement à celles du logement du premier élément de boîtier,
- une cale présentant deux ouvertures opposées sur ses grands côtés et une ouverture sur un petit côté, les dimensions de la cale correspondant sensiblement à celles du logement du premier élément de boîtier, la cale présentant sur sa face tournée vers la puce des retours latéraux opposés destinés à s'intercaler chacun entre un grand côté de la puce et un bord correspondant du premier logement, ainsi qu'au moins une patte d'extrémité destinée à s'intercaler entre un petit côté de la puce et un bord correspondant du premier logement, et au moins une portion destinée à s'engager dans le logement entre la puce et l'élément de boîtier inférieur, du côté opposé à la patte d'extrémité ;
- une cale présentant deux ouvertures opposées sur ses grands côtés et une ouverture sur un petit côté, les dimensions de la cale correspondant sensiblement à celles du logement du premier élément de boîtier, la cale présentant au moins deux portions destinées chacune à s'interposer entre un petit côté de la cale et un bord correspondant du logement, la cale présentant sur sa face tournée vers la puce des retours latéraux opposés destinés à s'intercaler chacun entre un grand côté de la puce et un bord correspondant du premier logement, la cale présentant en outre au moins une piste conductrice agencée pour se superposer au moins partiellement à un contact de la puce et à un élément de connectique.

Les ouvertures précitées, de chaque cale, peuvent se présenter sous la forme d'encoches.

Dans un exemple de mise en oeuvre de l'invention, le procédé comporte la mise en place :
- d'un élément de boîtier supérieur présentant un deuxième logement de réception d'une deuxième puce,
- d'un élément de boîtier intermédiaire disposé entre les éléments supérieur et inférieur,
- d'une deuxième puce au moins partiellement reçue dans le deuxième logement, présentant des contacts électriques,
- d'éléments de connectique reliés électriquement aux contacts électriques des puces,
- d'au moins une capacité reliée électriquement à l'une au moins des puces et/ou aux éléments de connectique.

Le procédé comporte avantageusement l'utilisation d'un guide d'assemblage présentant au moins un logement principal adapté à recevoir au moins l'élément de boîtier inférieur. Ce guide d'assemblage présente de préférence des logements secondaires adaptés à recevoir les éléments de connectique.

Le logement principal peut présenter un fond comportant au moins une empreinte de réception d'un écrou ou d'une tête de vis, et le procédé peut comporter le positionnement dans le logement principal d'au moins un écrou ou d'une tête de vis avant la mise en place dans celui-ci d'élément de boîtier inférieur notamment.

Le procédé peut comporter le positionnement dans le fond du logement principal d'un élément de transfert thermique, notamment une plaque métallique, de préférence du cuivre. Dans un exemple de mise en oeuvre, le procédé comporte les étapes successives suivantes :
- la mise en place optionnelle dans le logement principal du guide d'assemblage d'écrous dans les logements correspondants éventuellement prévus au fond de celui-ci,
- la mise en place d'un élément de transfert thermique, de préférence sous forme de plaque métallique, dans le logement principal, recouvrant les écrous le cas échéant,
- la mise en place de l'élément de boîtier inférieur sur l'élément de transfert métallique,
- la mise en place de la première puce dans le logement défini par le premier élément de boîtier,
- la mise en place de la cale sur la première puce,
- la mise en place d'éléments de connectique venant recouvrir au moins un contact de la puce et/ou une piste à relier électriquement à un contact de la puce,
- la mise en place de l'élément de boîtier intermédiaire,
- la mise en place de la capacité sur l'un des éléments de connectique, notamment dans un logement correspondant de l'élément de boîtier intermédiaire, cette capacité présentant un premier contact électrique en regard de l'élément de connectique sur lequel elle est déposée,
- la mise en place d'au moins un autre élément de connectique s'étendant au moins partiellement en regard d'un deuxième contact électrique de la capacité,
- la mise en place sur l'ensemble présent dans le logement principal du guide d'assemblage de l'élément supérieur de boîtier,
- la mise en place dans le logement de l'élément supérieur de boîtier de la deuxième puce,
- la mise en place d'un deuxième élément de transfert thermique, notamment sous forme de plaque métallique, de préférence en cuivre,
- l'assemblage des éléments de boîtier ainsi superposés, à l'aide le cas échéant de vis engagées dans les écrous, et
- l'établissement des contacts électriques par soudure, notamment en soumettant l'ensemble à une température provoquant la fonte d'une pâte de brasage présente entre les surfaces à souder.

Le procédé peut comporter le remplacement d'une cale par une autre de forme différente, adaptée à un modèle de puce différent.

L'invention a encore pour objet le guide d'assemblage en tant que tel, ainsi que le guide d'assemblage et l'ensemble des composants du module destinés à s'assembler à l'aide du guide.

### Brève description des dessins

L'invention pourra être mieux comprise à la lecture de la description détaillée qui va suivre, d'exemples de mise en oeuvre non limitatifs de celle-ci, et à l'examen du dessin annexé, sur lequel :
[Fig 1] la figure 1 est une vue en perspective d'un exemple de module de puissance selon l'invention,
[Fig 2] la figure 2 est une vue éclatée du module de la figure 1, ainsi que du guide d'assemblage,
[Fig 3] la figure 3 représente isolément le guide d'assemblage,
[Fig 4] la figure 4 illustre la mise en place des écrous dans le fond du logement principal du guide d'assemblage,
[Fig 5] la figure 5 illustre la mise en place de la première plaque de cuivre dans le logement principal du guide d'assemblage,
[Fig 6] la figure 6 illustre la mise en place du premier élément de boîtier dans le logement principal du guide d'assemblage,
[Fig 7] la figure 7 illustre la mise en place de la première puce dans le logement défini par le premier élément de boîtier,
[Fig 8] la figure 8 illustre la mise en place de la cale sur la première puce,
[Fig 9] la figure 9 illustre la mise en place des premiers éléments de connectique,
[Fig 10] la figure 10 illustre la mise en place de l'élément de boîtier intermédiaire,
[Fig 11] la figure 11 illustre la mise en place de la capacité,
[Fig 12] la figure 12 illustre la mise en place des autres éléments de connectique,
[Fig 13] la figure 13 illustre la mise en place de l'élément de boîtier supérieur,
[Fig 14] la figure 14 illustre la mise en place de la deuxième puce dans le logement de l'élément de boîtier supérieur,
[Fig 15] la figure 15 illustre la mise en place de la deuxième plaque de cuivre sur la deuxième puce,
[Fig 16] la figure 16 illustre la mise en place de vis de maintien,
[Fig 17] la figure 17 représente isolément la cale,
[Fig 18] la figure 18 est une vue analogue à la figure 7 dans le cas de l'utilisation d'une puce différente,
[Fig 19] la figure 19 représente isolément un exemple de cale adaptée à la puce de la figure 18,
[Fig 20] la figure 20 est une vue en perspective de la cale de la figure 19 sous un autre angle de vue,
[Fig 21] la figure 21 est une vue analogue à la figure 7 dans le cas de l'utilisation d'une puce différente,
[Fig 22] la figure 22 représente isolément un exemple de cale adaptée à la puce de la figure 21,
[Fig 23] la figure 23 est une vue en perspective de la cale de la figure 22 sous un autre angle de vue, et
[Fig 24] la figure 24 illustre l'établissement des connexions électriques entre les éléments de connectique et la puce.

### Description détaillée

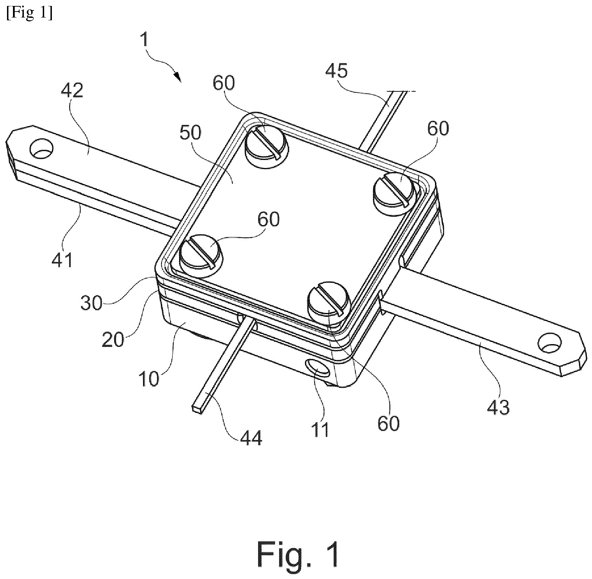

Le module de puissance 1 représenté sur la figure 1 comporte trois éléments de boîtier superposés, à savoir un premier élément de boîtier 10, inférieur, un deuxième élément de boîtier 20, intermédiaire, et un troisième élément de boîtier 30, supérieur.

Le module 1 comporte également des éléments de connectique, à savoir dans l'exemple illustré des pattes métalliques 41 et 42 s'étendant en vis-vis d'un premier côté du module 1, une patte métallique 43 s'étendant du côté opposé, et des pattes métalliques opposées 44 et 45 s'étendant à partir des deux autres côtés.

Le module 1 peut comporter comme illustré sur ses faces principales des plaques de transfert thermique, dont l'une 50, est visible sur la figure 1.

Les différents éléments de boîtier ainsi que les plaques de transfert thermique peuvent être maintenues par des vis 60, comme illustré.

Le module 1 est représenté sur la figure 1 avant une encapsulation éventuelle.

L'un au moins des éléments de boîtier, par exemple l'élément inférieur 10, peut comporter une ouverture 11 permettant l'injection d'une résine isolante de remplissage, dite « underfiller ».

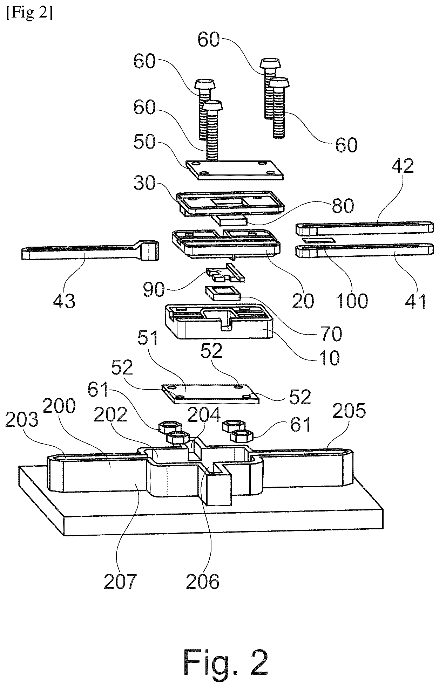

Si l'on se reporte à la figure 2, on voir que le module 1 comporte des première 70 et deuxième 80 puces électroniques, et au moins une cale 90.

On peut voir également sur cette figure la plaque de transfert thermique inférieure 51 et les écrous 61 dans lesquels les vis 60 viennent en prise.

Une capacité 100 peut être disposée entre les éléments de connectique 41 et 42.

Les puces 80 et 90 sont par exemple des transistors de puissance, par exemple à base de GaN ; on a par exemple la source de l'un reliée au drain de l'autre par un point milieu, et les éléments de connectique 41 et 42 sont par exemple reliés au drain de l'un et à la source de l'autre, tandis que l'élément de connectique 43 est relié au point milieu. Les éléments de connectique 44 et 45 sont par exemple reliés aux grilles de ces transistors.

La capacité 100 est par exemple un condensateur de découplage, dont la valeur est par exemple de quelques nF.

Sur la figure 2, on a également représenté un guide d'assemblage 200 utilisé lors de la fabrication du module 1.

Ce guide 200 est par exemple en matière plastique et peut être réalisé avec des tolérances de fabrication relativement grossières par moulage par injection.

Il peut comporter une base horizontale 201 surmontée d'une paroi verticale 207 qui définit un logement principal 202 et quatre logements secondaires 203 à 206, disposés autour du logement principal 202 comme le sont les éléments de connectique sur le module.

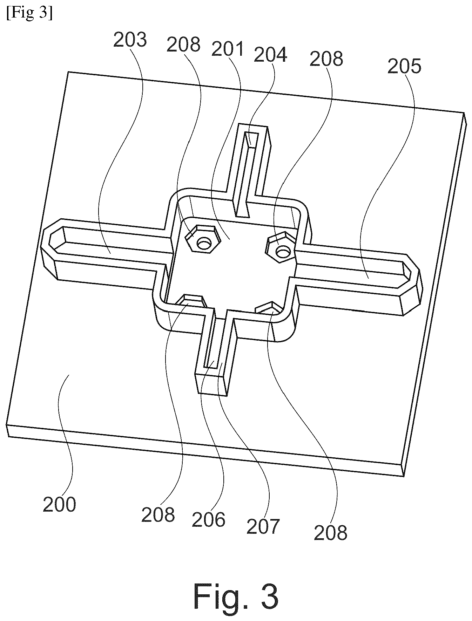

Le guide d'assemblage a été représenté isolément à la figure 3. On peut voir que le fond du logement principal 201 comporte des empreintes 208 de réception des écrous 61.

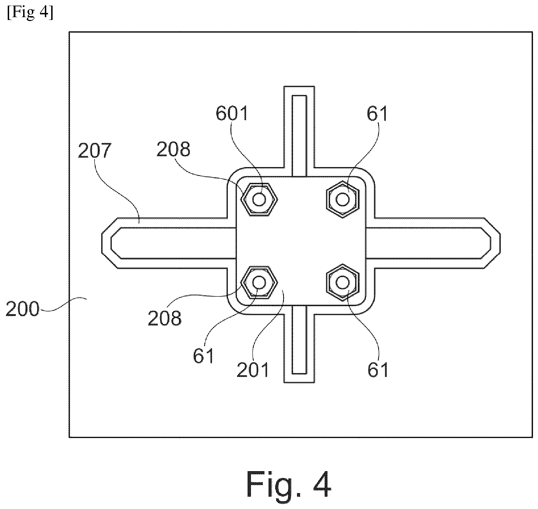

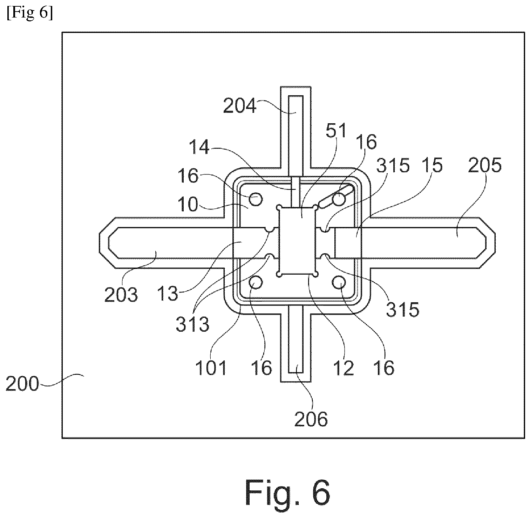

On va maintenant décrire plus avant, en se référant aux figures 4 à 17, les divers éléments constitutifs du module ainsi qu'un exemple de procédé de fabrication de celui-ci.

Le procédé de fabrication peut commencer, lorsque des vis sont utilisées pour maintenir les éléments de boîtier assemblés, par disposer les écrous 61 dans les empreintes 208 correspondantes, comme illustré à la figure 4.

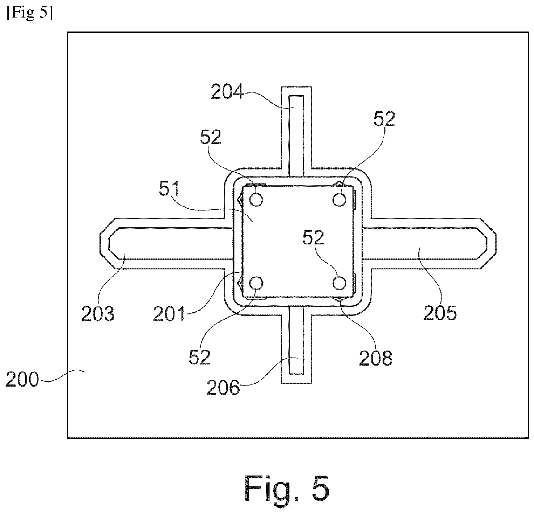

Ensuite, comme illustré sur la figure 5, la plaque inférieure 51 est posée dans le fond du logement 201 ; cette plaque comporte des trous 52 pour le passage des vis 60.

Dans l'exemple considéré, la plaque 51 est en cuivre, mais elle peut être remplacée par tout dissipateur adapté, par exemple en un autre métal ou en une céramique conductrice de la chaleur.

La pose des différents éléments constitutifs du module peut se faire par tout outillage adapté, notamment un outillage conventionnel de type « pick and place ».

L'élément de boîtier inférieur 10 peut alors être déposé dans le logement 101.

Cet élément 10 comporte un premier logement central 12, traversant, destiné à recevoir la première puce 70, et des logements non traversants 13, 14 et 15 pour recevoir respectivement les éléments de connectique 41, 45 et 43. Ces logements 13, 14 et 15 débouchent dans les logements 203, 204 et 205 du guide 200, respectivement. Des trous 16 sont prévus pour le passage des vis 60.

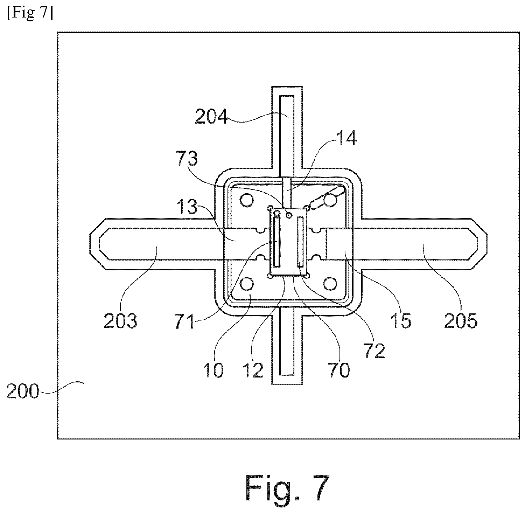

On a représenté sur la figure 7 le guide 200 après pose de la puce 70 dans le logement 12.

Dans cet exemple, la puce 70 présente une forme générale parallélépipédique dont le contour en vue de dessus correspond sensiblement à celui du logement 12.

La puce 70 peut présenter sur sa face interne des contacts électriques 71, 72 et 73.

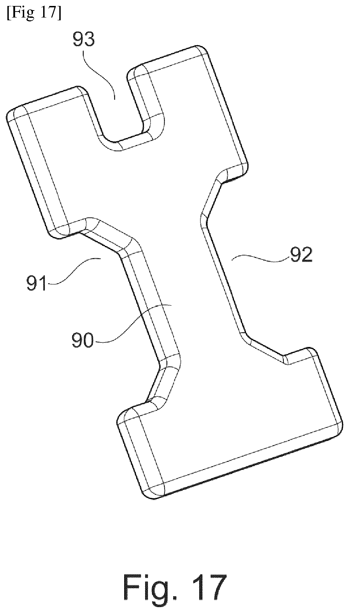

On a représenté isolément sur la figure 17 la cale 90.

Celle-ci présente des longueur et largeur adaptées à son positionnement dans le logement 12 avec un faible jeu.

Elle peut être réalisée en tout matériau isolant électrique compatible avec les conditions d'utilisation, par exemple une céramique ou une matière polymère.

La cale 90 présente deux ouvertures latérales 91 et 92 et une ouverture 93 en extrémité, sous forme d'encoches.

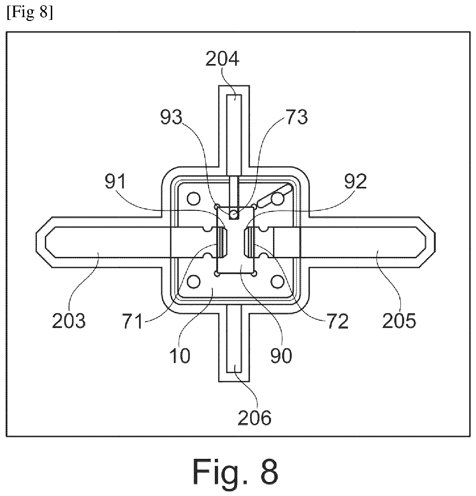

Une fois la cale 90 posée sur la puce 70, comme illustré à la figure 8, les contacts 71, 72 et 73 restent accessibles au travers des ouvertures 91, 92 et 93 respectivement.

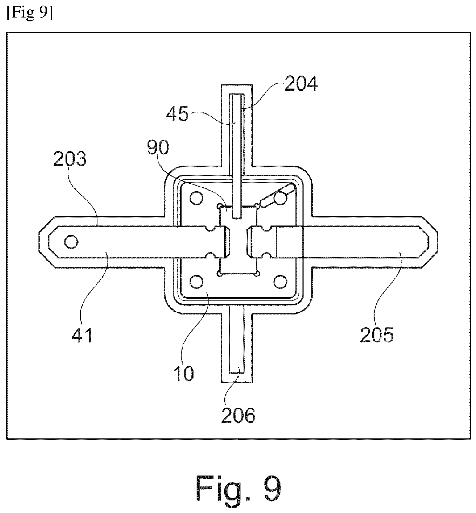

Les éléments de connectique 41 et 45 peuvent alors être placés dans les logements 203 et 204, respectivement, en venant recouvrir partiellement les contacts 71 et 73, comme illustré sur la figure 9. Une pâte à braser peut être déposée à l'interface entre les contacts de la puce et les éléments de connectique, en vue d'une soudure ultérieure.

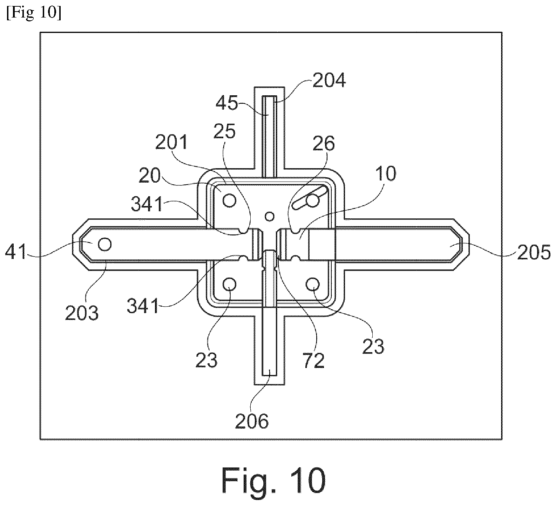

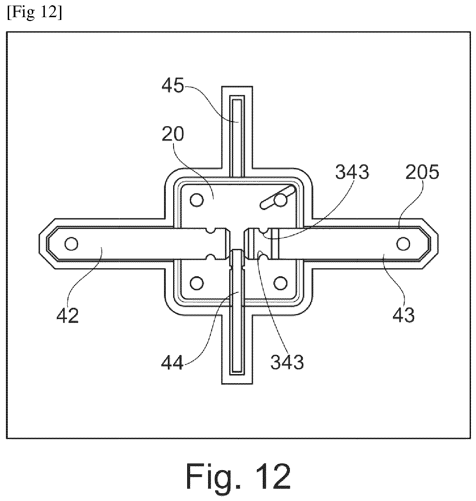

Il peut être utile de réaliser dans les logements 13 et 15 des reliefs 313 et 315 destinés à coopérer avec des reliefs correspondants des éléments de connectique reçus dans ces logements, de manière à améliorer le positionnement et le maintien des éléments de connectique durant les opérations d'assemblage. Les reliefs 313 ou 315 se présentent par exemple sous la forme de bossages se faisant face et l'élément de connectique présente alors deux encoches 341 ou 343, visibles sur les figures 10 et 12 respectivement, destinées à s'ajuster sur ces bossages.

Des reliefs coopérants sous forme de bossages et encoches entre les éléments de boîtier et les éléments de connectique peuvent exister pour chacun des cinq éléments de connectique du module, comme visible sur les figures, et ne seront pas décrits de façon détaillée à chaque fois dans la suite.

Ensuite, l'élément de boîtier intermédiaire 20 peut être mis en place dans le logement 201 pour recouvrir les composants déjà présents.

L'élément 20 présente des trous 23 pour le passage des vis 60, et des ouvertures 24, 25 et 26 destinées à recevoir les éléments de connectique 44, 42 et 43 respectivement.

L'ouverture 26 ménage un accès au contact 72 de la puce 70.

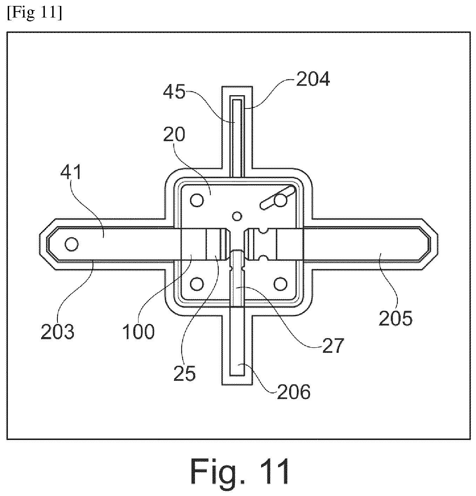

A l'étape illustrée sur la figure 11, la capacité 100 est posée sur l'élément de connectique 41, dans l'ouverture 25.

L'élément de connectique 42 peut alors être mis en place pour recouvrir la capacité 100, comme illustré sur la figure 12, et la capacité 100 sert d'entretoise entre les éléments de connectique 41 et 42.

L'élément de connectique 43 est mis en place du côté opposé.

De la pâte à braser est disposée lorsque nécessaire entre les composants à souder, notamment entre la capacité 100 et les éléments de connectique 41 et 42 et entre l'élément de connectique 43 et le contact correspondant 72 de la puce 70.

L'élément de connectique 44 est mis en place dans un logement correspondant 27 de l'élément de boîtier 20.

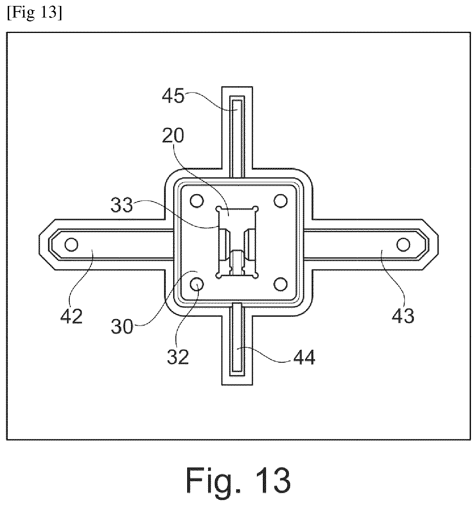

Ensuite, l'élément de boîtier 30 est mis en place sur les éléments de connectique précédemment installés, comme illustré à la figure 13.

L'élément de boîtier 30 dispose d'une ouverture centrale 33, par exemple de forme rectangulaire, comme illustré. Cette ouverture 33 ménage un accès aux éléments de connectique 42, 43 et 44.

L'élément de boîtier 30 comporte des trous 32 pour le passage des vis 60.

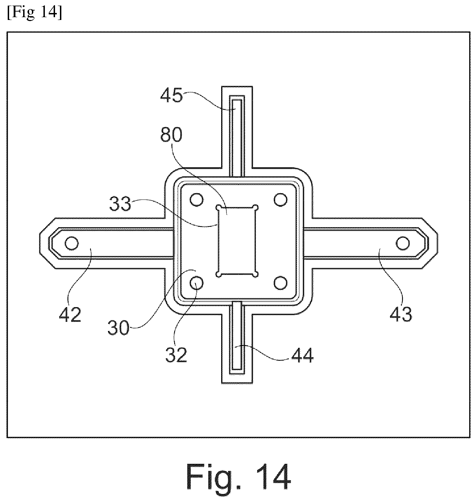

La deuxième puce 80 peut ensuite être disposée dans le logement 33, comme illustré à la figure 14.

Cette puce 80 dispose de contacts sur sa face tournée vers l'intérieur, qui sont positionnés en regard des éléments des connectique 42, 43 et 44 respectivement.

Une pâte à braser peut être disposée à l'interface entre les contacts de la puce 80 et les éléments de connectique, de manière à permettre la soudure lors d'une étape de cuisson ultérieure.

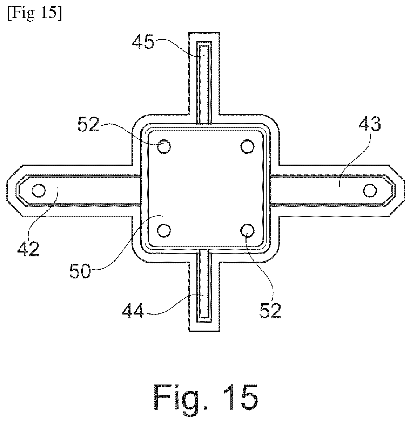

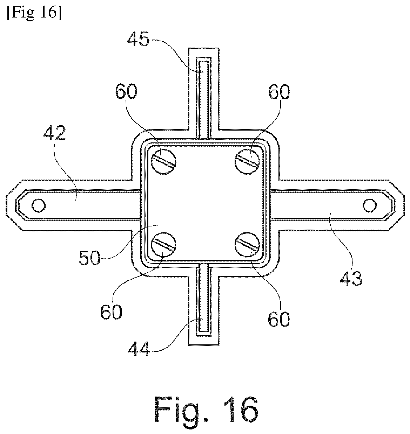

Une fois la puce 80 en place, une deuxième plaque 50 de transfert thermique, par exemple en cuivre, peut être placée contre la puce 80, comme illustré à la figure 15, cette plaque 50 étant par exemple identique à la première plaque 51, et comportant tout comme celle-ci des trous pour le passage des vis 60. Ces dernières peuvent alors être montées et engagées sur les écrous 61 présents dans le fond du logement principal 202 du guide 200, comme illustré à la figure 16.

Une fois les vis 60 serrées, l'ensemble peut être sorti du guide 200 et cuit dans un four à une température adaptée à la fusion de la pâte à braser et à la réalisation des soudures à effectuer entre les différents composants du module.

Après soudure, une résine de remplissage peut être injectée par l'orifice 11 et l'ensemble peut être encapsulé si besoin dans une résine d'encapsulage, en laissant les éléments de connectique accessibles, ainsi le cas échéant que les plaques de cuivre lorsque le couplage thermique à un radiateur est prévu.

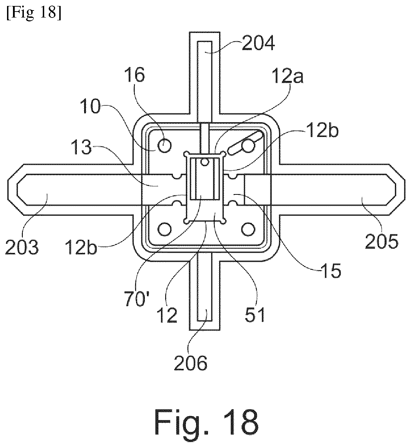

L'utilisation d'une cale 90 est avantageuse, car elle permet de remplacer la première puce 70 par une deuxième 70' de format différent, sans modifier l'élément de boîtier inférieur 10, comme illustré à la figure 18.

Dans l'exemple illustré, la puce 70' présente des dimensions inférieures à celles de la puce 70.

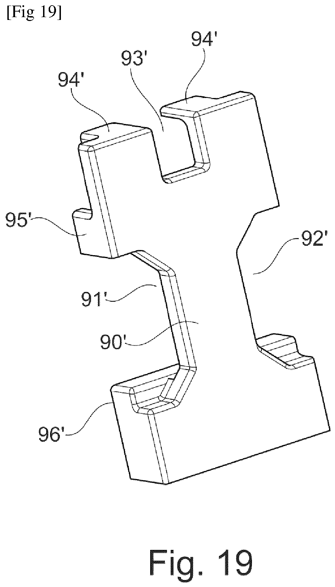

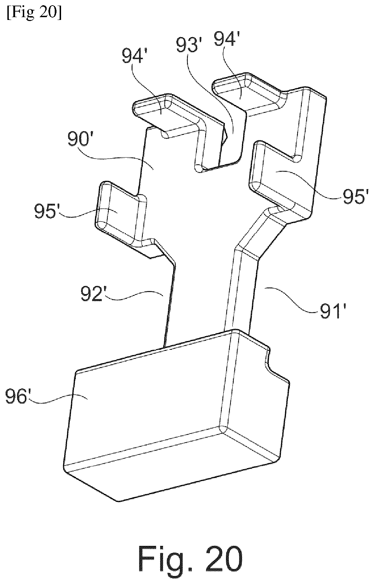

La cale 90 peut être remplacée par une cale 90' représentée isolément sur les figures 19 et 20, présentant des ouvertures 91', 92' et 93' comme la cale 90, ainsi que sur une face des portions saillantes destinées à s'engager dans l'espace ménagé entre la puce 90' et le bord du logement 12.

Dans l'exemple considéré, la cale 90' comporte ainsi deux pattes d'extrémité 94' situées de part et d'autre de l'ouverture 93', destinées à s'engager entre la puce 70' et le petit côté 12a du logement 12.

La cale 90' comporte également deux pattes latérales 95' configurée chacune pour s'insérer entre un grand côté de la puce 70' et un grand côté 12b du logement.

La cale 90' comporte, du côté opposé aux pattes 94', un talon 96' agencé pour s'engager entre la puce 70' et l'autre petit côté 12a du logement 12.

Ainsi, la cale 90' se positionne précisément dans le logement 12, du fait de ses dimensions extérieures, tout en maintenant la puce 70' précisément au sein du logement 12, à un emplacement qui convient à l'établissement des connexions électriques avec les éléments de connectique associés.

Lorsque le modèle de puce utilisé n'a pas les mêmes contacts électriques que ceux des autres puces utilisées, la cale peut comporter au moins une piste conductrice permettant de relier électriquement au moins un contact correspondant de la puce à un élément de connectique associé.

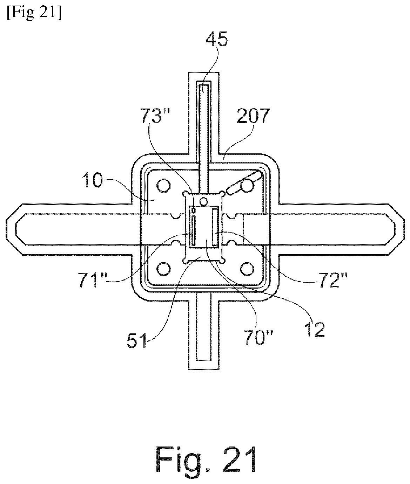

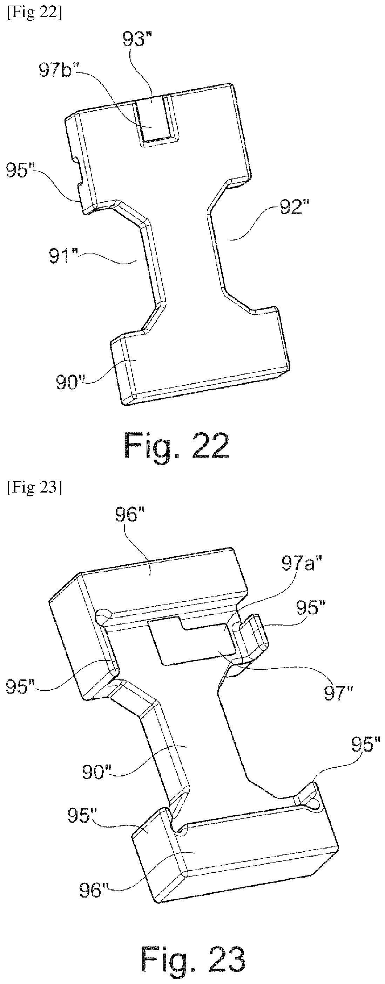

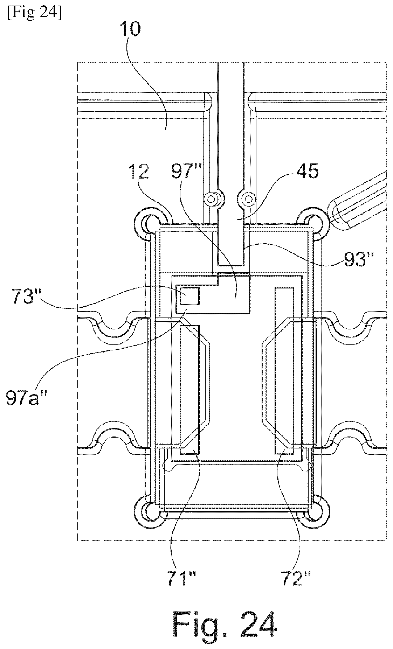

A titre d'exemple, on a illustré sur les figures 21 à 24 une telle situation.

On a représenté sur la figure 21 une variante de puce 70" qui est non seulement plus petite que la puce 70, tout comme la puce 70', mais qui en outre présente des contacts 71", 72" et 73" disposés autrement, avec notamment un contact 73" décalé latéralement de l'élément de connectique 45. Sur la figure 21, l'élément de connectique a été représenté pour illustrer ce décalage, bien que mis en place ultérieurement.

La cale 90" présente, comme les autres cales 90 et 90', des logements 91", 92" et 93", pour recevoir respectivement les extrémités des éléments de connectique 41, 43 et 45.

La cale 90" comporte des reliefs permettant de positionner la puce 70" dans le logement 12, par exemple des pattes latérales 95" et des portions d'extrémité 96".

Les pattes 95" peuvent pour certaines se prolonger jusqu'à la portion d'extrémité adjacente.

La cale 90" comporte une piste conductrice 97", par exemple en forme de coude comme illustré, positionnée de manière à venir se superposer par une extrémité 97a" avec le contact 73". La piste 97" s'étend à l'autre extrémité 97b" dans le fond du logement 93", afin d'être connectée à l'élément de connectique 45.

La piste 97" est par exemple intégrée dans la cale 90" lors du processus de fabrication de cette dernière Cela peut être une pièce métallique insérée dans la céramique ou réalisée par injection ou sérigraphie.

Les éléments de boîtier 10, 20 et 30, ainsi que la cale 90, 90' ou 90", peuvent être fabriqués de manière à préexister lors de l'assemblage, en tout(s) matériau(x) isolant(s) électrique(s) compatible(s) avec l'utilisation recherchée, par exemple en une céramique, notamment par un procédé d'impression 3D ou de frittage. Le matériau est choisi pour résister thermiquement à l'opération de soudure des contacts, et la chaleur dégagée lors de l'utilisation normale du module et à l'environnement de fonctionnement ; ainsi l'assemblage peut résister à une température d'au moins 150°C par exemple.

Pour réaliser les connexions électriques, une pâte à braser peut être utilisée, l'invention n'étant pas limitée à une technique particulière d'établissement des connexions électriques.

L'invention n'est pas limitée aux exemples qui viennent d'être décrits.

Par exemple, le module peut comporter plus d'une cale, et l'on peut notamment utiliser une deuxième cale pour permettre le montage comme deuxième puce, de puces de tailles et/ou d'implémentation de contacts différentes ; le cas échéant, l'élément de boîtier intermédiaire est modifié également pour faciliter l'adaptation de modèles de puces différents.

On peut aussi assembler au sein d'un module plus de deux puces, et utiliser une ou plusieurs cales permettant d'utiliser des modèles de puces différents.

Les logements des éléments de boîtier destinés à recevoir les puces peuvent présenter une forme autre que rectangulaire, par exemple carrée ou autre. On peut avoir plusieurs logements destinés à recevoir des puces respectives sur un même élément de boîtier, et avoir une ou plusieurs cales associées à ces puces.

Certains éléments de connectique, par exemple les éléments 44 et 45 reliés aux grilles des transistors, peuvent sortir d'un même côté du boîtier pour faciliter la commande du module.

## Revendications

1. Module de puissance (1) comportant
- Un premier élément de boîtier (10) présentant un premier logement (12) de réception d'une première puce (70 ; 70' ; 70"),
- une première puce (70 ; 70' ; 70") au moins partiellement reçue dans le premier logement, présentant des contacts électriques (71, 72, 73 ; 71', 72', 73' ; 71", 72", 73"),
- des éléments de connectique (41, 43, 45) reliés électriquement aux contacts électriques de la première puce,
- au moins une cale isolante (90 ; 90' ; 90") disposée au moins partiellement dans le premier logement de manière à recouvrir au moins partiellement ladite puce, présentant au moins une ouverture (91, 92 ; 91', 92' ; 91", 92") ménageant un accès à au moins un contact électrique de la puce à travers la cale et/ou au moins une piste (97") assurant la connexion avec l'un des éléments de connectique et/ou une capacité éventuelle.

2. Module selon la revendication 1, comportant :
- un deuxième élément de boîtier (30) présentant un deuxième logement (33) de réception d'une deuxième puce (80),
- un troisième élément de boîtier (20) disposé entre les premier et deuxième éléments de boîtier, notamment présentant au moins un troisième logement (25) de réception d'une capacité (100),
- une deuxième puce (80) au moins partiellement reçue dans le deuxième logement, présentant des contacts électriques,
- des éléments de connectique (42, 44) reliés électriquement aux contacts électriques de la deuxième puce,
- au moins une capacité (100) reçue au moins partiellement dans le troisième logement (25) et reliée électriquement à l'une au moins des puces et/ou aux éléments de connectique (41, 42).

3. Module selon la revendication 1 ou 2, la cale (90 ; 90' ; 90") présentant sur un bord au moins une ouverture latérale dans laquelle s'engage un élément de connectique correspondant, connecté électriquement à un contact de la puce.

4. Module selon la revendication 3, la cale présentant sur deux bords longitudinaux opposés deux ouvertures latérales respectives dans lesquelles s'engagent deux éléments de connectiques correspondants connectés électriquement à deux contacts respectifs de la puce.

5. Module selon l'une quelconque des revendications précédentes, la cale étant plus longue que la puce à son contact, et présentant au moins une portion (96' ; 96") engagée dans le logement entre la puce et l'élément de boîtier définissant le logement recevant la puce en contact avec la cale.

6. Module selon la revendication précédente, la cale s'interposant sur au moins trois côtés, notamment quatre côtés, entre la puce et l'élément de boîtier définissant le logement recevant la puce en contact avec la cale.

7. Module selon l'une quelconque des revendications précédentes, la cale ayant une face sensiblement coplanaire avec une face de l'élément de boîtier définissant le logement recevant la puce en contact avec la cale.

8. Module selon l'une quelconque des revendications précédentes, l'élément de boîtier intermédiaire (20) présentant des logements de réception d'éléments de connectique positionnés de manière à permettre de superposer ceux-ci avec des contacts électrique de la deuxième puce.

9. Module selon l'une quelconque des revendications précédentes, les éléments de boîtier étant traversés par des trous permettant le passage d'organes de maintien des éléments de boîtier à l'état assemblé, notamment des vis (60).

10. Module selon l'une quelconque des revendications précédentes, comportant au moins un élément de transfert thermique (50 ; 51) en contact avec une face extérieure d'une puce, mieux deux éléments de transfert thermique en contact chacun avec une face extérieure d'une puce respective, ce ou ces éléments de transfert thermique comportant chacun de préférence une plaque d'un métal, de préférence du cuivre.

11. Gamme de modules de puissance, comportant au moins un premier et un deuxième module (1) selon l'une quelconque des revendications précédentes, au moins l'une des puces du premier module étant différente d'une puce correspondante de l'autre module, les deux modules comportant des cales différentes et des éléments de boîtier (10, 20) identiques.

12. Procédé de fabrication d'un module de puissance, notamment un module (1) selon l'une quelconque des revendications 1 à 10, ce module comportant :
- un élément de boîtier inférieur (10) présentant un premier logement de réception d'une première puce,
- une première puce (70 ; 70' ; 70") au moins partiellement reçue dans le premier logement, présentant des contacts électriques,
le procédé comportant les étapes consistant à :
- recouvrir avec une cale isolante (90 ; 90' ; 90") la puce présente dans le premier logement, cette cale définissant au moins une ouverture (91, 92 ; 91', 92' ; 91", 92") se superposant à au moins un contact électrique de la puce ou présentant une piste électrique (97") à relier à un contact électrique de la puce, notamment une piste débouchant sur une ouverture de la cale destinée à recevoir un élément de connectique.

13. Procédé selon la revendication 12, comportant l'utilisation d'un guide d'assemblage (200) présentant au moins un logement principal (201) adapté à recevoir au moins l'élément de boîtier inférieur.

14. Procédé selon l'une des revendications 12 ou 13, comportant le positionnement dans le fond du logement principal d'un élément de transfert thermique, notamment une plaque métallique, de préférence du cuivre.

15. Procédé selon les revendications 12 à 14, comportant les étapes successives suivantes :
- la mise en place optionnelle dans le logement principal du guide d'assemblage d'écrous dans les logements correspondants éventuellement prévus au fond de celui-ci,
- la mise en place d'un élément de transfert thermique, de préférence sous forme de plaque métallique, dans le logement principal, recouvrant les écrous le cas échéant,
- la mise en place de l'élément de boîtier inférieur (10) sur l'élément de transfert métallique,
- la mise en place de la première puce (70 ; 70' ; 70") dans le logement (12) défini par le premier élément de boîtier,
- la mise en place de la cale (90 ; 90' ; 90") sur la première puce,
- la mise en place d'éléments de connectique venant recouvrir au moins un contact de la puce et/ou une piste à relier électriquement à un contact de la puce,
- la mise en place de l'élément de boîtier intermédiaire (20),
- la mise en place de la capacité (100) sur l'un des éléments de connectique, notamment dans un logement correspondant de l'élément de boîtier intermédiaire, cette capacité présentant un premier contact électrique en regard de l'élément de connectique sur lequel elle est déposée,
- la mise en place d'au moins un autre élément de connectique s'étendant au moins partiellement en regard d'un deuxième contact électrique de la capacité (100),
- la mise en place sur l'ensemble présent dans le logement principal du guide d'assemblage de l'élément supérieur de boîtier (30),
- la mise en place dans le logement de l'élément supérieur de boîtier de la deuxième puce (80),
- la mise en place d'un deuxième élément de transfert thermique (50), notamment sous forme de plaque métallique, de préférence en cuivre,
- l'assemblage des éléments de boîtier ainsi superposés, à l'aide le cas échéant de vis (60) engagées dans les écrous,
- l'établissement des contacts électriques par soudure.
